# EUROPÄISCHE PATENTANMELDUNG

(11) **EP 1 431 714 A1**
(43) Veröffentlichungstag der Anmeldung: **23.06.2004**
(21) Anmeldenummer: 03028662.9
(22) Anmeldetag: 16.12.2003
(51) Int. Cl.: G01D 21/02, G01R 31/36

(54) **Verfahren und Vorrichtung zur Datenerfassung**

(30) Priorität: 20.12.2002 DE 10260177
(71) Anmelder: DaimlerChrysler AG, 70567 Stuttgart (DE)
(72) Erfinder: Hornung, Hans-Georg, 86875 Waal (DE)

(57) **Zusammenfassung**

Die Erfassung eines abgeleiteten Datenwerts aus an einer Mehrzahl von in einer festgelegten Reihenfolge hintereinandergeschalteten Dateneinheiten (2-i, 3-i) erzeugten Einzeldatenwerten findet statt, indem jede Dateneinheit(2-i, 3-i), der eine Vorgänger-Dateneinheit (2-(i-1), 3-(i-1)) zugeordnet ist, einen Datenwert von dieser Vorgänger-Dateneinheit empfängt, mit einem von ihr selbst erzeugten Einzeldatenwert (D) verknüpft und den so erhaltenen Datenwert weitergibt, wodurch der von der letzten Dateneinheit (2-M, 3-M) weitergegebene Datenwert den abgeleiteten Datenwert darstellt. Die Weitergabe erfolgt bitweise seriell, wobei jede Dateneinheit (2-i, 3-i) ein empfangenes Bit mit dem entsprechenden Bit eines eigenen Einzeldatenwerts verknüpft und weitergibt, bevor sie ein weiteres Bit des Datenwerts empfängt.

## Beschreibung

Die vorliegende Erfindung betrifft ein Verfahren und eine Vorrichtung zur Datenerfassung, insbesondere, aber nicht ausschließlich zur Erfassung eines abgeleiteten Datenwertes aus an einer Mehrzahl von Dateneinheiten erzeugten Einzeldatenwerten.

Ein herkömmliches Verfahren zum Erzeugen eines solchen abgeleiteten Datenwertes ist, die über einen Bus oder dergleichen mit einer Steuereinheit wie etwa einem Mikroprozessor verbundenen Dateneinheiten der Reihe nach zu adressieren, um sie zu veranlassen, ihre Einzeldatenwerte an die Steuereinheit auszugeben, und anschließend an der Steuereinheit die Ableitung des abgeleiteten Datenwertes aus den Einzeldatenwerten vorzunehmen. Ein solches Verfahren ist technisch aufwendig, da jede einzelne Dateneinheit über eine Schnittstelle verfügen muss, die in der Lage ist, eine Adressierung der betreffenden Dateneinheit durch die Steuereinheit zu erkennen, und sie führt zu einem beträchtlichen Datenverkehr auf dem Bus, auf dem die Anforderungen an die Dateneinheiten, einen Einzeldatenwert zu liefern, und deren Antworten sukzessive übertragen werden müssen. Eine besonders hohe Belastung ergibt sich, wenn ein paketorientierter Bus verwendet werden muss, so etwa, weil neben den Einzeldatenwerte liefernden Dateneinheiten auch Dateneinheiten angebunden werden müssen, die große Datenmengen in kurzer Zeit senden oder empfangen.

Aus WO 00/68700 sind ein Verfahren und eine Vorrichtung zum Erfassen eines abgeleiteten Datenwertes aus an einer Mehrzahl von Dateneinheiten erzeugten Datenwerten bekannt, bei denen die Dateneinheiten nicht parallel an einem Bus liegen, sondern in Reihe geschaltet sind, so dass jede Dateneinheit Datenwerte nicht von beliebigen anderen Dateneinheiten empfangen und an beliebige andere Dateneinheiten senden kann, sondern Datenwerte jeweils nur von einer ihr vorgelagerten Dateneinheit empfangen, ggf. mit einem eigenen Datenwert verknüpfen und das Ergebnis an eine nachfolgende Dateneinheit weitergeben kann. Bei einer solchen Anordnung entfällt die Notwendigkeit, jede Dateneinheit einzeln zu adressieren, so dass die einzelnen Dateneinheiten auch keinen Adressdecoder benötigen und dadurch vereinfacht werden können. Die Zeitspanne, die zur Gewinnung eines abgeleiteten Datenwertes erforderlich ist, ist allerdings recht lang, da die einzelnen Dateneinheiten untereinander seriell verbunden sind und jede Dateneinheit einen Datenwert vollständig von einer Vorgänger-Dateneinheit empfangen haben muss, bevor sie die Verknüpfung mit dem eigenen Einzeldatenwert durchführt und schließlich das Ergebnis weitergibt.

Es wäre zwar möglich, diese Verzögerungen zu verringern, indem eine parallele Übertragung der Datenwerte zwischen benachbarten Dateneinheiten vorgesehen wird, doch eine solche Lösung ist aufwendig und kostspielig, insbesondere, wenn die Dateneinheiten in einer Umgebung eingesetzt werden, in der elektromagnetische Störungen häufig sind und deshalb eine Abschirmung der Datenleitung erforderlich ist.

Eine Aufgabe der vorliegenden Erfindung ist, ein Verfahren und eine Vorrichtung zum Erfassen eines abgeleiteten Datenwertes aus an einer Mehrzahl von Dateneinheiten erzeugten Einzeldatenwerten anzugeben, die eine schnellere Erfassung ermöglichen, ohne dass hierfür ein wesentlich erhöhter Schaltungs- und Verdrahtungsaufwand erforderlich ist.

Die Aufgabe wird dadurch gelöst, dass jede Dateneinheit ihren Datenwert seriell in Form von aufeinanderfolgenden Abschnitten weitergibt, und dass jede Dateneinheit, die einen Abschnitt eines solchen Datenwertes empfängt, diesen mit dem entsprechenden Abschnitt eines eigenen Einzeldatenwertes verknüpft und weitergibt, bevor sie einen weiteren Abschnitt des Datenwertes empfängt. Auf diese Weise kann der Vorgang des Verknüpfens des weitergebenen Datenwertes mit Einzeldatenwerten der verschiedenen Dateneinheiten auf mehrere Dateneinheiten verteilt gleichzeitig stattfinden, wobei zu einem gegebenen Zeitpunkt jede Dateneinheit einen anderen Abschnitt des Datenwertes verarbeitet.

Die schrittweise Weitergabe der Datenwerte bzw. ihrer Abschnitte von einer vorhergehenden an eine nachfolgende Dateneinheit ist auf einfache Weise realisierbar über eine aus einer Folge von signaltechnisch getrennten Abschnitten aufgebaute Datenleitung, deren Abschnitte sich jeweils von einem Sender der vorhergehenden zu einem Empfänger der nachfolgenden Dateneinheit erstrecken.

Vorzugsweise handelt es sich bei den Abschnitten der Datenwerte jeweils um einzelne Bits.

Eine einfache logische Verknüpfung wie etwa eine Und- oder Oder-Verknüpfung der einzelnen Abschnitte kann ohne Berücksichtigung von zuvor verarbeiteten Abschnitten des gleichen Datenwertes erfolgen. Bei den meisten praktischen Anwendungen jedoch ist es beim Verknüpfen eines Abschnitts des weitergegebenen Datenwertes mit dem entsprechenden Abschnitt eines Einzeldatenwertes erforderlich, das Ergebnis der Verknüpfung des unmittelbar vorhergehenden Paars von Abschnitten des Einzeldatenwerts und des weitergegebenen Datenwerts zu berücksichtigen.

Die Reihenfolge, in der die Abschnitte verknüpft werden, richtet sich nach der Art der durchzuführenden Verknüpfung. Wenn der abgeleitete Datenwert ein Minimum oder ein Maximum der Einzeldatenwerte ist, werden die Abschnitte zweckmäßigerweise in der Reihenfolge abnehmender Signifikanz weitergegeben; wenn der abgeleitete Datenwert eine Summe oder eine Differenz der Einzeldatenwerte ist, erfolgt die Weitergabe der Abschnitte in der Reihenfolge zunehmender Signifikanz.

Jede Dateneinheit, die eine Vorgänger-Dateneinheit hat, kann in einfacher Weise durch Empfang eines weitergegebenen Datenwertes von der Vorgänger-Dateneinheit veranlasst werden, eine Verknüpfung vorzunehmen. Die erste Dateneinheit könnte einen Triggereingang aufweisen, und durch ein dem Triggereingang zugeführtes Triggersignal veranlasst werden, einen von ihr gewonnenen Einzeldatenwert weiterzugeben. Vorzugsweise ist allerdings die erste Dateneinheit mit allen anderen Dateneinheiten baugleich und wird getriggert durch Zuführen eines neutralen Datenwertes, das heißt eines Datenwertes, dessen Verknüpfung mit dem Einzeldatenwert der ersten Dateneinheit diesen Einzeldatenwert als Ergebnis hat. Das heißt, wenn die durchzuführende Verknüpfung eine Summation ist, so ist ein neutraler Datenwert Null, wenn die Verknüpfung die Bildung eines Minimums oder eines Maximums ist, so ist der neutrale Datenwert die im jeweils zur Darstellung der Datenwerte verwendeten Format kleinste bzw. größte darstellbare Zahl.

Vielseitiger ist jedoch eine Erfassungsvorrichtung bzw. ein Erfassungsverfahren, bei dem nicht nur Datenwerte von einer Dateneinheit zur nächsten weitergegeben werden, sondern auch Befehle übermittelt werden, die den einzelnen Dateneinheiten anzeigen, wie ggf. empfangene Datenwerte zu verarbeiten sind. Zur Übermittlung der Befehle kann z. B. eine von einer Datenleitung getrennte Statusleitung eingesetzt werden, deren Status jederzeit anzeigt, wie mit ein empfangener Datenwert zu verarbeiten ist. Besonders zweckmäßig ist, auf einer gemeinsamen Datenleitung Datenwerte und Befehle, die die Verarbeitung eines Datenwerts festlegen, nacheinander zu übertragen, vorzugsweise in Form von zeitlich beabstandeten Impulssalven oder -zügen, die jeweils einen Befehlsabschnitt und einem Parameterabschnitt umfassen, wobei in letzterem jeweils ein Datenwert übertragen wird, auf den der im Befehlsabschnitt übertragene Befehl anzuwenden ist.

Ein Befehl zum Gewinnen eines Einzeldatenwertes wird zweckmäßigerweise allen Dateneinheiten gleichzeitig zugeleitet, so dass die erfassten Einzeldatenwerte jeweils einem gleichen Zeitpunkt entsprechen, auch wenn sie in den Dateneinheiten anschließend zu verschiedenen Zeitpunkten verknüpft werden. Zu diesem Zweck ist vorzugsweise jede Dateneinheit mit einem Abtast-Halteglied ausgestattet.

Bei Anwendungen, bei denen die zu erfassenden Datenwerte langsam variieren und daher kleine Unterschiede in den Erfassungszeitpunkten der einzelnen Dateneinheiten toleriert werden können, kann der Befehl zum Gewinnen eines Einzeldatenwertes auch auf der Datenleitung sukzessive von einer Dateneinheit zur anderen weitergegeben werden. Diese Lösung hat den Vorteil, dass zum Übertragen des Erfassungsbefehls keine eigene Leitung benötigt wird.

Eine bevorzugte Anwendung des erfindungsgemäßen Verfahrens bzw. der erfindungsgemäßen Vorrichtung ist die Erfassung von Messgrößen, insbesondere von Spannungen einer Reihenanordnung von elektrischen Energiequellen wie etwa Zellen eines Brennstoffzellenstapels. Bei dieser Anwendung hat die Tatsache, dass die Dateneinheiten nicht alle mit einem gemeinsamen Bus, sondern nur jeweils paarweise untereinander verbunden sind, den zusätzlichen Vorteil, dass die paarweisen Verbindungen so gelegt werden können, dass keine großen Potentialdifferenzen zwischen den ihnen zugeordneten Brennstoffzellen auftreten.

Für die zeitliche Steuerung der Weitergabe der Datenwerte zwischen den Dateneinheiten sind diese vorzugsweise durch eine Taktleitung verbunden. Dabei kann es sich um eine durchgehende Taktleitung handeln, an welche alle Dateneinheiten parallel angebunden sind, vorzugsweise umfasst die Taktleitung jedoch - wie auch die Datenleitung - eine Mehrzahl von signaltechnisch getrennten Abschnitten, die sich jeweils von einem Sender einer ersten Dateneinheit zu einem Empfänger einer zweiten Dateneinheit erstrecken. Vorzugsweise verläuft ein Abschnitt der Taktleitung jeweils zwischen zwei Dateneinheiten, die auch durch einen Abschnitt der Datenleitung verbunden sind, und das von einem Sender jeder Dateneinheit gesendete Taktsignal hat eine Verzögerung von einer halben Taktperiode gegenüber dem vom Empfänger der gleichen Dateneinheit empfangenen Taktsignal. Mit dieser Maßnahme lässt sich die Dauer der Erfassung des abgeleiteten Datenwertes nochmals verringern.

Da die an den einzelnen Dateneinheiten durchzuführenden Operationen erfindungsgemäß im wesentlichen einfache Einzelbit-Operationen sind, eignet sich die Dateneinheiten gemäß der Erfindung besonders zur Realisierung in einem oder mehreren ASICs.

Gegenstand der Erfindung ist auch ein Verfahren zum Adressieren einer Dateneinheit aus einer Mehrzahl von Dateneinheiten, bei dem zunächst eine Reihenfolge der Dateneinheiten festgelegt wird, z. B. durch die Reihenfolge, in der sie entlang der Dateneinheit angeordnet worden sind, bei dem jede Dateneinheit, der eine Vorgänger-Dateneinheit zugeordnet ist, einen Adresswert von dieser Vorgänger-Dateneinheit empfängt, den Adresswert mit einem für alle Dateneinheiten gleich vorgegebenen Wert vergleicht, bei Übereinstimmung mit dem vorgegebenen Wert adressiert ist und wenigstens bei Nichtübereinstimmung den Adresswert durch eine vorgegebene Operation verändert und den so erhaltenen Adresswert weitergibt.

Insbesondere wenn es sich bei der vorgegebenen Operation um eine Inkrementierung oder eine Dekrementierung handelt, kann ein solcher Adresswert in ähnlicher Weise wie der oben erwähnte weitergegebene Datenwert seriell in Form von aufeinanderfolgenden Abschnitten bzw. Bits zunehmender Signifikanz weitergegeben werden, wobei jede Dateneinheit, die einen Abschnitt eines Adresswerts empfängt, diesen je nachdem, ob zur Inkrementierung bzw. Dekrementierung nötig, verändert oder nicht verändert, und ihn weitergibt, bevor sie einen weiteren Abschnitt des Adresswertes empfängt. Basierend auf einer solchen Adressierung kann aus den von den oben beschriebenen Dateneinheiten aufgenommenen einzelnen Datenwerten auch jeweils ein von der adressierten Dateneinheit erzeugter Einzeldatenwert selektiert und über eventuelle Nachfolger-Dateneinheiten der adressierten Dateneinheit an einen Empfänger weitergeleitet werden.

Weitere Merkmale und Vorteile der Erfindung ergeben sich aus der nachfolgenden Beschreibung von Ausführungsbeispielen unter Bezugnahme auf die beigefügten Figuren.

Dabei zeigen:
- Fig. 1: ein Blockdiagramm eines Brennstoffzellenstapels mit einer daran angeschlossenen Vorrichtung zur Erfassung von Klemmenspannungen der einzelnen Brennstoffzellen gemäß der Erfindung;
- Fig. 2: ein Flussdiagramm eines Verfahrens zum Erfassen des Maximums der Klemmenspannungen der Brennstoffzellen;
- Fig. 3: ein Flussdiagramm eines Verfahrens zum Erfassen der Summe der Klemmenspannungen der Brennstoffzellen;
- Fig. 4: den zeitlichen Verlauf von Takt- und Datensignalen in der Vorrichtung aus Fig. 1; und
- Fig. 5: ein Flussdiagramm eines Verfahrens zum Adressieren einer einzelnen Messstelle der Vorrichtung aus Fig. 1 und zum Erfassen der von der Messstelle gemessenen Klemmenspannung.

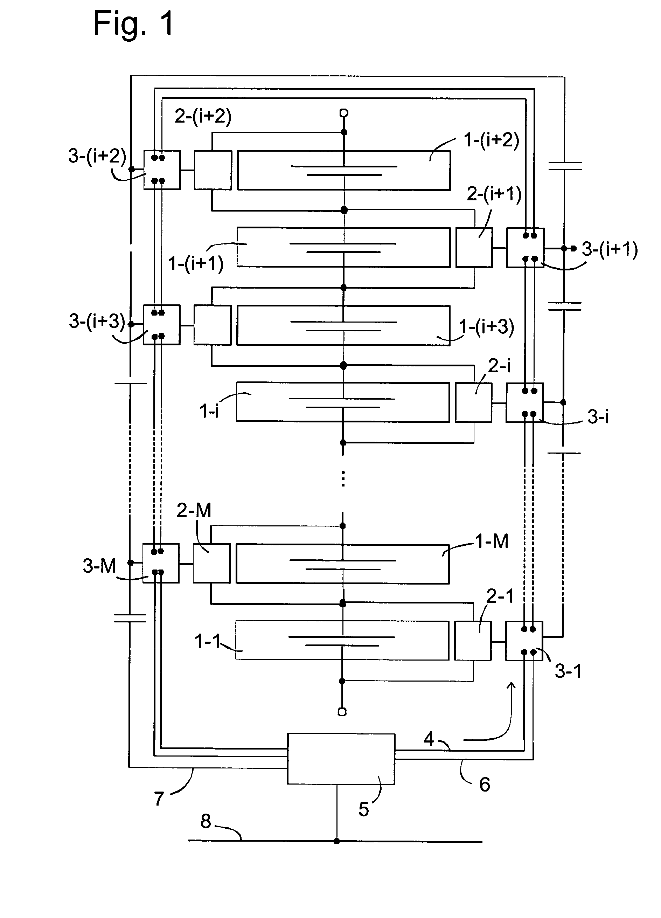

Das Blockdiagramm der Fig. 1 zeigt einen Stapel von M in Reihe geschalteten Brennstoffzellen 1-1 bis 1-M, denen jeweils eine Messstelle bestehend aus einem AD-Wandler 2-i und einer Schnittstelle 3-i, i=1, ..., M, zugeordnet ist. Der AD-Wandler 2-i ist jeweils mit den Anschlussklemmen der zugeordneten Brennstoffzelle 1-i verbunden, um deren Klemmenspannung zu erfassen und einen für die erfasste Spannung repräsentativen digitalen Wert an die Schnittstellenschaltung 3-i zu liefern. Eine einadrige Datenleitung 4 verläuft ringförmig ausgehend von einer Steuereinheit 5 der Reihe nach über die Schnittstellen 3-i und zurück zu der Steuereinheit 5. Die Datenleitung 4 setzt sich zusammen aus einer Mehrzahl von voneinander signaltechnisch getrennten Abschnitten, d. h. von Abschnitten, die jeweils einen Sender der Steuereinheit 5 mit einem Empfänger der ersten Schnittstelle 3-1 des Kreises oder einen Sender einer Schnittstelle 3-i mit einem Empfänger darauffolgenden Schnittstelle 3-(i+1) bzw. im Falle der letzten Schnittstelle 3-M, mit einem Empfänger der Steuereinheit 5 verbinden. Die Datenleitung überträgt also nur in einer Richtung, im Gegenuhrzeigersinn in Fig. 1, und jede Schnittstelle hat die Kontrolle darüber, ob sie ein an ihrem Empfänger eintreffendes Signal über ihren Sender weitergibt.

Bei der Ausgestaltung der Fig. 1 verbinden die meisten Abschnitte der Datenleitung 4 jeweils Schnittstellen 3 von Brennstoffzellen 1 miteinander, die in der Reihenschaltung der Brennstoffzellen übernächste Nachbarn sind. Die Schnittstellen liegen jeweils schwebend auf dem Potential der ihnen zugeordneten Brennstoffzelle. Somit entspricht die von jedem Abschnitt der Datenleitung 4 zu überbrückende Potentialdifferenz zwischen den Schnittstellen jeweils der zweifachen Klemmenspannung der Brennstoffzellen 1-i. Da somit die Potentialdifferenz zwischen entlang der Datenleitung 4 benachbarten Schnittstellen 3-i gering ist, ist eine Gleichspannungsentkopplung zwischen ihnen auf einfache Weise, zum Beispiel mit Hilfe eines (nicht dargestellten) in jeden Abschnitt der Datenleitung 4 eingefügten Kondensators, möglich. Selbstverständlich wäre es auch möglich, auf der Datenleitung 4 jeweils die Schnittstellen von in dem Brennstoffzellenstapel elektrisch unmittelbar miteinander verbundenen Brennstoffzellen zu verbinden, in diesem Falle wäre allerdings in einem Abschnitt der Datenleitung 4 eine der Gesamtausgangsspannung des Brennstoffzellenstapels entsprechende Potentialdifferenz zu überbrücken, was aufwendigere Mittel zur Gleichspannungsentkopplung wie etwa einen Optokoppler erforderlich machen kann.

Eine Taktleitung 6 ist parallel zu der Datenleitung 4 ringförmig von der Steuereinheit 5 über die Schnittstellen 3-1 bis 3-M und zurück zu der Steuereinheit 5 geführt. Wie die Datenleitung 4 besteht sie aus einer Mehrzahl von signaltechnisch getrennten Abschnitten, die jeweils einen Sender der Steuereinheit 5 oder einer Schnittstelle 3-i mit einem Empfänger einer darauffolgenden Schnittstelle 3-(i+1) oder der Steuereinheit 5 verbinden.

Die Schnittstellen 3-i sind ferner parallel an eine mehradrige Statusleitung 7 angeschlossen, die von der Steuereinheit 5 ausgeht und auf der die Schnittstellen 3 zeitgleich Status- oder Befehlssignale von der Steuereinheit 5 empfangen. Eine Ader der Statusleitung 7 kann zum Beispiel zum Übertragen eines Abtastbefehls an sämtliche Messstellen dienen, der diese veranlasst, einen Spannungswert der zugeordneten Brennstoffzelle aufzunehmen. Ein Abtast-Halteglied zum Zwischenspeichern dieses Spannungswertes bis zum Zeitpunkt seiner Abfrage durch die Steuereinheit 5 kann in Form einer Analogschaltung zwischen den Anschlussklemmen jeder Brennstoffzelle 1-i und des zugeordneten AD-Wandlers 2-i oder in Form eines digitalen Puffers zwischen dem AD-Wandler 2-i und dessen Schnittstelle 3-i vorgesehen sein.

Die Statusleitung 7 kann entfallen, wenn einer bevorzugten Weiterentwicklung zufolge die Schnittstellen 3-i ausgelegt sind, um von der Steuereinheit 5 über die Datenleitung 4 gesendete Befehle von Daten zu unterscheiden und auszuwerten. Dies ist z. B. möglich, indem Daten auf der Datenleitung 4 in Form von voneinander zeitlich beabstandeten Zügen oder Salven übertragen werden und die Schnittstellen jeweils eine festgelegte Zahl von Bits am Anfang jedes Zuges als Befehl interpretieren.

Die Steuereinheit 5 ist ihrerseits an einen CAN-Bus 8 eines Kraftfahrzeuges angeschlossen, über den sie von einem nicht dargestellten Prozessor Befehle zum Liefern bestimmter Datenwerte an den Prozessor empfängt bzw. diese Datenwerte sendet.

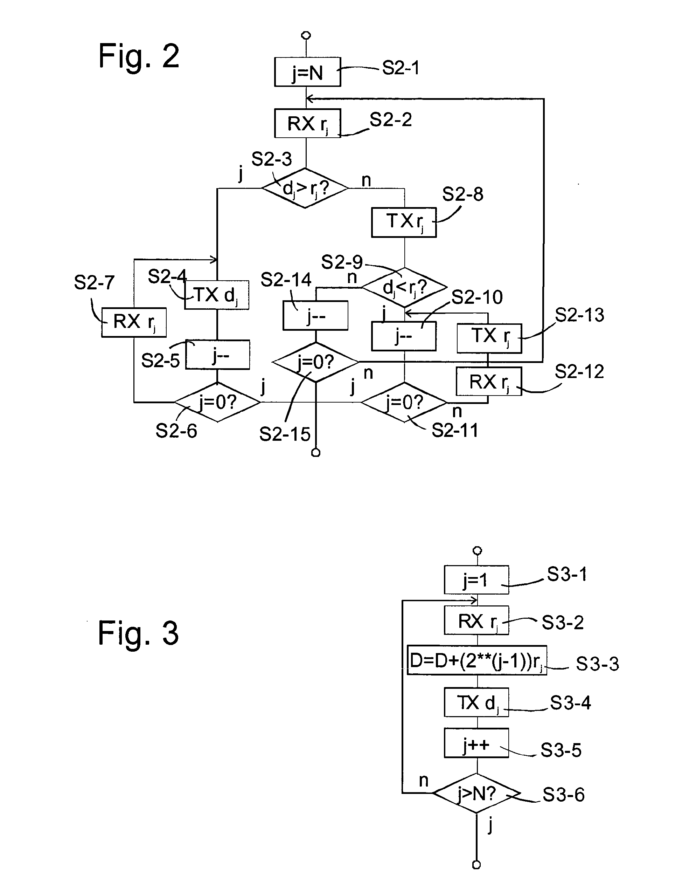

Die Arbeitsweise der in Fig. 1 gezeigten Vorrichtung soll nun anhand mehrerer Beispiele erläutert werden. Es wird zunächst der Fall betrachtet, dass die Steuereinheit 5 vom Prozessor den Befehl empfängt, das Maximum aller zu einem festgelegten Zeitpunkt an den Anschlussklemmen der Brennstoffzellen 1 anliegenden Spannungen zu liefern. Daraufhin sendet die Steuereinheit 5 zunächst, wie oben angegeben, einen Befehl zum Abtasten und Halten der Klemmenspannung an alle Schnittstellen 3-i. Ein solcher Befehl kann, wie oben angegeben, als Signal auf einer Ader der Statusleitung 7 oder als Teil eines Bitzuges auf der Datenleitung 4 übertragen werden. Anschließend beginnt die Steuereinheit 5, synchron zu einem Taktsignal, das sie gleichzeitig über die Taktleitung 6 an die erste Schnittstelle 3-1 sendet, Bit für Bit ein N Bit breites Datenwort zu senden, dessen Bits sämtlich Null sind, wobei N die Auflösung der AD-Wandler 2 ist. Es ist nicht erforderlich, dass die Steuereinheit 5 abwartet, bis die Digitalisierung der aufgenommenen Datenwerte beendet ist, bevor sie das erste der N Bits "Null" sendet. Es genügt, dass zu Beginn des Sendens das höchstwertige Bit des abgetasteten Datenwertes an der Schnittstelle 3-1 vorliegt, und dass die AD-Wandler 2-i die weiteren Bits mit wenigstens derselben Rate liefern, mit der die Steuereinheit 5 sendet. Die Verarbeitung, die die Schnittstellen 3-i durchführen, wenn sie von einer vorgeschalteten Schnittstelle 3-(i-1) oder im Fall der Schnittstelle 3-1 von der Steuereinheit 5 einen Datenwert empfangen, ist für alle Schnittstellen die gleiche und wird mit Bezug auf Fig. 2 beschrieben.

Zu Beginn wird in Schritt S1 ein internes Register j der Schnittstelle 3-i mit dem Wert N belegt. Das daraufhin auf der Datenleitung empfangene Bit rⱼ (Schritt S2-2) wird mit dem gleich signifikanten Bit dⱼ des vom AD-Wandler 2-i erfassten Datenwortes D verglichen (S2-3). Wenn dⱼ > rⱼ ist, so bedeutet dies, egal, welche Werte die noch zu übertragenden Bits von R haben, dass der von dem AD-Wandler 2-i erfasste Datenwert D größer als R sein muss. In diesem Fall geht das Verfahren über zu Schritt S2-4, sendet das Bit dⱼ an die nachfolgende Schnittstelle 3-(i+1) und dekrementiert in Schritt S2-5 den Zähler j. Wenn dieser den Wert Null erreicht hat (S2-6), so bedeutet dies, dass alle N Bits verarbeitet worden sind, und das Verfahren endet. Anderenfalls wird ein weiteres Bit rⱼ empfangen (S2-7), und das Verfahren kehrt zu Schritt S2-4 zurück, wo dieses Bit weitergesendet wird.

Wenn der Vergleich von Schritt S2-3 ergibt, dass dⱼ nicht größer als rⱼ ist, wird in Schritt S2-8 das Bit rⱼ weitergesendet. Es folgt ein Vergleich (S2-9), ob dⱼ kleiner als rⱼ ist. Wenn dies der Fall ist, steht automatisch fest, dass - ungeachtet der Werte eventuell noch folgender, weniger signifikanter Bits von R oder D - der Datenwert R größer als D sein muss, so dass die Schnittstelle 3-i in eine Schleife eintritt, in der ohne einen weiteren Größenvergleich so oft j dekrementiert wird (S2-10), ein weiteres Bit rⱼ empfangen (S2-12) und weitergesendet (S2-13) wird, bis j=0 ist (S2-11).

Wenn der Vergleich in Schritt S2-9 ergibt, dass dⱼ nicht kleiner als rⱼ ist, so ist noch offen, welcher der Werte R und D der größere ist. Nach Dekrementieren von j (S2-14) und Vergleichen, ob j=0 ist, kehrt das Verfahren daher zu Schritt S2-2 zurück.

Der von der Schnittstellenschaltung 3-i weitergebene Datenwert R ist also der jeweils größere unter dem von ihr empfangenen Datenwert R und dem von ihr selbst aufgenommenen Einzeldatenwert D.

Wenn alle Schnittstellen die Verarbeitung gemäß Fig. 2 durchgeführt haben, empfängt schließlich die Steuereinheit 5 als Erfassungsergebnis das Maximum aller von den Messstellen 2, 3 aufgenommenen Einzeldatenwerte.

Eine Erfassung des Minimums aller von den Messstellen aufgenommenen Datenwerte ist in analoger Weise möglich, wenn der von der Steuereinheit 5 an die erste Schnittstelle 3-1 gesendete neutrale Datenwert aus N Bits "1" besteht und die Vergleiche der Schritte S2-3 und S2-9 vertauscht werden.

Bei einer vorteilhaften Weiterentwicklung des Verfahrens wird kein Zähler j verwendet; es entfallen der Initialisierungsschritt S2-1 und die Dekrementierungen S2-5, S2-10, S2-14. Stattdessen wird der Inhalt eines Schieberegisters, in dem zu Beginn des Verfahrens der erfasste Einzeldatenwert D gespeichert ist, und der das jeweils signifikanteste gespeicherte Bit ausgibt, jeweils in den Schritten S2-5, S2-10, S2-14 um ein Bit nach links verschoben, wodurch ebenfalls erreicht wird, dass die Bits von D sukzessive ausgegeben und mit den jeweils gleich signifikanten Bits von R verglichen werden, bis feststeht, welcher Wert der größere (oder kleinere) von beiden ist, und der jeweils ausgewählte Wert als neuer Wert R an die nächste Schnittstellenschaltung weitergegeben wird. Als Abbruchkriterium in den Schritten S2-6, S2-11 und S2-15 wird die Zeitspanne zwischen sukzessive an der Schnittstelle 3 eintreffenden Bits des Werts R angewendet: Bleibt ein Folgebit länger als eine vorgegebene Zeitspanne aus, so beendet die Schnittstelle das Verfahren. Dieses Verfahren ermöglicht unter anderem einen schnellen Vergleich mit eingeschränkter Genauigkeit: die Zahl der Bits von R kann kleiner als die Auflösung der AD-Wandler 2 sein; in einem solchen Fall bleiben wenig signifikante Bits der Datenwerte D unausgewertet.

Mit der Vorrichtung der Fig. 1 ist es auch auf einfache Weise möglich, die Summe aller Klemmenspannungen der Brennstoffzellen zu erfassen, indem anstelle des Verfahrens der Fig. 2 das der Fig. 3 ausgeführt wird. Die Steuerschaltung 5 sendet wie im Falle der Ermittlung des Maximums eine Folge von Bits "0" an die erste Schnittstelle 3-1. Jede Schnittstelle führt das in Fig. 3 gezeigte Verfahren aus. Zunächst setzt sie den Zähler j auf 1 (S3-1), um anschließend (S3-2) das Bit rⱼ zu empfangen. In Schritt S3-3 wird dieses Bit unter Berücksichtigung seiner Signifikanz, das heißt multipliziert mit einem Faktor 2^{j-1}, zu dem von der betreffenden Messstelle erfassten Einzeldatenwert D hinzuaddiert, wobei sich ein Übertrag in dessen nächstsignifikanteres Bit dᵢ₊₁ ergeben kann. Das dabei erhaltene Bit dᵢ wird in Schritt S3-4 an die nächste Schnittstelle 3 oder, wenn die betrachtete Schnittstelle die letzte ist, an die Steuereinheit 5 weitergegeben. Nach Inkrementieren des Zählers j (S3-5) wird überprüft (S3-6), ob insgesamt N Bits verarbeitet worden sind. Wenn nein, kehrt das Verfahren zu Schritt S3-2 zurück, wenn ja, ist es beendet.

Wie man sieht, ist bei der Summation gemäß Fig. 3 die Reihenfolge, in der die Bits verarbeitet werden, eine andere, als bei der Bestimmung des Maximums oder Minimums gemäß Fig. 2.

Beide Verfahren sind wahlweise in einer gleichen Vorrichtung gemäß Fig. 1 durchführbar, wenn auf der Statusleitung 7 eine Ader vorgesehen wird oder ein auf der Datenleitung übertragbarer Befehl definiert ist, die/der es der Steuereinheit 5 ermöglicht, den Betriebsmodus der Schnittstellen, gemäß Fig. 2 oder gemäß Fig. 3, festzulegen.

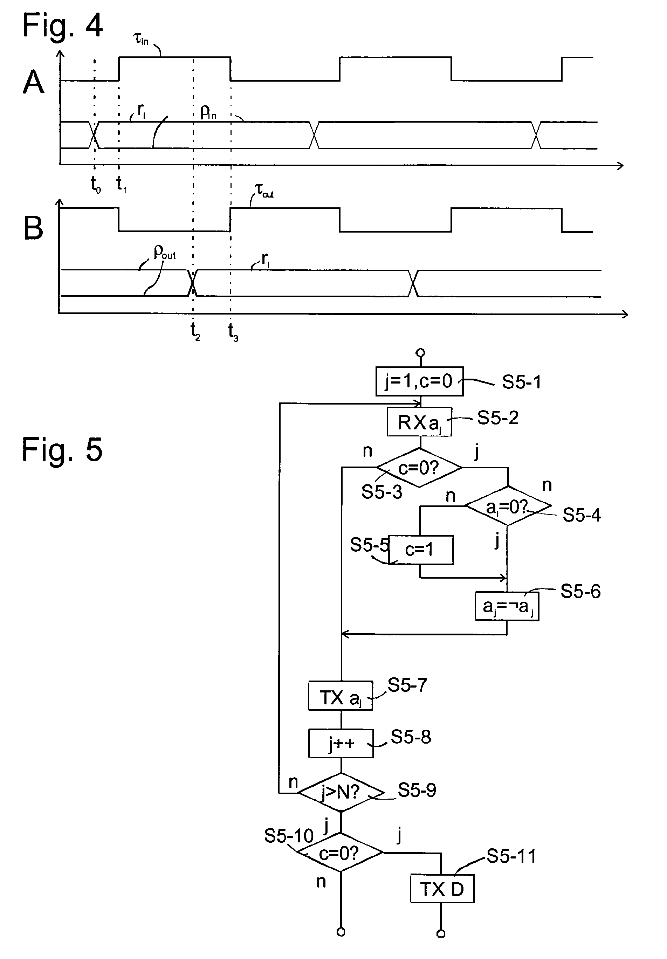

Fig. 4 zeigt den zeitlichen Verlauf von Takt- und Datensignalen am Eingang (Diagramm A) bzw. am Ausgang (Diagramm B) einer Schnittstelle 3-i. Zum Zeitpunkt t₀, jeweils beim Übergang von einem Bit des zu übertragenden Datenwertes R zum nächsten, kann das Datensignal, in Fig. 4 mit ρᵢₙ bezeichnet, seinen Pegel wechseln. Mit einer kurzen Verzögerung, die zum Stabilisieren der Pegel auf der Datenleitung erforderlich ist, zum Zeitpunkt t₁, hat das Taktsignal τᵢₙ eine ansteigende Flanke, welche die Schnittstelle 3-i veranlasst, den am Eingang anliegenden Wert rⱼ zu übernehmen. Die Schnittstelle 3 führt die Verknüpfung zwischen dem empfangenen Bit rⱼ und dem entsprechenden Bit dⱼ des von ihr gewonnenen Einzeldatenwertes D aus, wie oben mit Bezug auf Fig. 2 oder Fig. 3 beschrieben. Das Ergebnis liegt zum Zeitpunkt t₂ vor und wird als Pegel rⱼ des Ausgangs-Datensignals ρₒᵤₜ ausgegeben, wie im Diagramm B gezeigt.

Die Schnittstelle 3-i erzeugt ein an eine nachgeordnete Schnittstelle 3-(i+1) weitergegebenes Taktsignal τₒᵤₜ mit einem Phasenversatz von einer halben Periode gegenüber dem empfangenen Taktsignal τᵢₙ. Wenn zum Zeitpunkt t₃ das Taktsignal τᵢₙ wieder abfällt und τₒᵤₜ eine ansteigende Flanke hat, veranlasst dies die nachgeordnete Schnittstelle 3-(i+1), den von der Schnittstelle 3-i ausgegebenen Pegel rⱼ zu übernehmen und zu verarbeiten. Dadurch beträgt die Zahl der Taktperioden, die ein Bit des Datenwerts D braucht, um die Reihenschaltung der Schnittstellen 3-1 bis 3-M zu durchlaufen, nur M/2, während bei einen synchron an allen Schnittstellen anliegenden Taktsignal M Perioden erforderlich wären.

Bei einer Weiterentwicklung des mit Bezug auf Fig. 3 beschriebenen Summationsverfahrens wird der Schritt S3-6 durch eine Überwachung des Taktsignals τᵢₙ ersetzt. Wenn dessen abfallende Flanke nicht innerhalb einer erwarteten Zeitspanne eintrifft, die die Schnittstelle 3-i aus einer Messung der Periodendauern vorhergehender Bits ableitet, so wird daraus der Schluss gezogen, dass die Übertragung von R beendet ist. Sofern aus der Summation der unmittelbar vorhergehenden Bits von D und R ein Übertragsbit existiert, oder wenn noch Bits des Datenwerts D unverarbeitet sind, sendet die Schnittstelle 3-i diese Bits zusammen mit selbst erzeugten Taktimpulsen an die nachgeordnete Schnittstelle 3-(i+1) und bricht anschließend ab; anderenfalls bricht sie die Übertragung mit Abbruch des empfangenen Taktsignals sofort ab. Bei diesem Verfahren kann die Bitzahl von R während des Durchlaufs durch die Kette der Schnittstellen beliebig anwachsen, d.h. eine beliebig große Zahl M von Schnittstellen kann hintereinandergeschaltet werden.

Eine Weiterentwicklung der Vorrichtung aus Fig. 1 erlaubt es, nicht nur Maxima, Minima und Summen der an den AD-Wandlern 2 anliegenden Spannungen zu erfassen, sondern auch selektiv die an einem einzelnen, wählbaren AD-Wandler 2-i anliegende Spannung zu erfassen. Für diese Weiterentwicklung ist entweder eine zusätzliche Adressleitung, die wie die Datenleitung 4 einadrig sein kann, zum Übertragen einer Adressinformation, oder eine zusätzliche Ader der Statusleitung 7 erforderlich, deren Pegel es jeder Schnittstelle 3-i ermöglicht, zu unterscheiden, ob die Datenleitung 4 zu einem gegebenen Zeitpunkt zur Übertragung eines Datenwertes oder der Adressinformation genutzt wird. Wenn auf der Datenleitung, wie oben beschrieben, nicht nur Daten, sondern auch Befehle übertragen werden können, so ist die Weiterentwicklung auch ohne Adress- und Statusleitung realisierbar; in diesem Fall wird die Adressinformation auf der Datenleitung jeweils in Verbindung mit einem Befehl übertragen, der jeweils unverändert von einer Schittstelle zur nächsten weitergegeben wird und der die Adressinformation für die Schnittstellen als solche kennzeichnet.

Die Arbeitsweise der Schaltung, die das selektive Lesen einzelner Spannungswerte ermöglicht, wird anhand des Flussdiagramms der Fig. 5 erläutert, wobei exemplarisch angenommen wird, dass die abzufragende Schnittstelle die Schnittstelle 3-3 ist. Unter der Annahme, dass die Zahl N der Bits der Adressinformation 4 ist, ist die zu übertragende Adressinformation "0010". Die Steuereinheit sendet diese Adress-Bits in der Reihenfolge zunehmender Signifikanz, das heißt in der Reihenfolge 0,1,0,0.

Die Schnittstelle 3-1, die unmittelbar an die Steuereinheit 5 angeschlossen ist, führt eine Initialisierung von zwei internen Registern j, c mit j=1, c=0 durch. In Schritt S5-2 empfängt sie das erste Adressbit a₁=0. Der Schritt S5-3 ist eine Verzweigung in Abhängigkeit vom Wert von c. Dieser ist zur Zeit 0, so dass das Verfahren zu Schritt S5-4 übergeht. Da a₁ gleich 0 ist, geht das Verfahren unmittelbar zu S5-6 über, wo a₁ negiert, also auf 1 gesetzt wird. Der erhaltene Wert wird an die Schnittstelle 3-2 weitergegeben (S5-7), der Zähler j wird inkrementiert (S5-8), und da er noch kleiner als N ist (S5-9), kehrt das Verfahren zu S5-2 zurück. Nun wird der Wert a₂ = 1 empfangen. Da c immer noch 0 ist, geht das Verfahren wieder zu S5-4 über, wobei allerdings in diesem Fall erst in Schritt S5-5 c=1 gesetzt wird, bevor in Schritt S5-6 a₂ negiert wird. Die Schritte S5-7 bis S5-9 werden wiederholt, und a₃ = 0 wird in Schritt S5-2 empfangen. Da nun c=1 ist, geht das Verfahren unmittelbar von S5-3 nach S5-7 über, das heißt a₃ und a₄ werden unverändert an die Schnittstelle 3-2 weitergegeben. Diese empfängt somit die Bitfolge 1,0,0,0, entsprechend dem Zahlenwert 1.

In dem Schritt S5-10 prüft die Schnittstelle 3-1 erneut, ob c=0 ist, und da dies nicht der Fall ist, endet für sie das Verfahren.

Die Schnittstelle 3-2 führt das Verfahren in gleicher Weise durch, mit der Folge, dass die Bitfolge 0,0,0,0 an die Schnittstelle 3-3 weitergegeben wird. Da bei Ausführung des Verfahrens auch in der Schnittstelle 3-2 c=1 gesetzt wird, endet auch hier das Verfahren mit Schritt S5-10.

In der Schnittstelle 3-3 führt das Verfahren dazu, dass Adressbits 1,1,1,1 weitergegeben werden und c=0 bleibt. Folglich verzweigt hier das Verfahren von Schritt S5-10 zum Schritt S5-11, und die Schnittstelle 3-3 ist adressiert. Wenn anschließend die Steuereinheit 5 einen Befehl zum Übertragen eines Einzeldatenwerts D an die Schnittstellen ausgibt, ist es die Schnittstelle 3-3, die ihn beantwortet; alle nachgeordneten Schnittstellen geben diesen Einzeldatenwert D weiter, ohne ihn zu manipulieren.

Wenn die Schnittstellen über getrennte Daten- und Adressleitungen verfügen, so genügt für die nachfolgenden Schnittstellen die Tatsache, dass die Statusleitung 7 den Modus der selektiven Adressierung anzeigt, und dass Daten auf der Datenleitung 4 übertragen werden, um zu erkennen, dass diese unverändert weiterzugeben sind.

## Patentansprüche

1. Verfahren zum Erfassen eines abgeleiteten Datenwerts aus an einer Mehrzahl von Dateneinheiten (2-i, 3-i) erzeugten Einzeldatenwerten, bei dem eine Reihenfolge der Dateneinheiten (2-i, 3-i) festgelegt wird, jede Dateneinheit(2-i, 3-i), der eine Vorgänger-Dateneinheit (2-(i-1), 3-(i-1)) zugeordnet ist, einen Datenwert (R) von dieser Vorgänger-Dateneinheit empfängt, mit einem von ihr selbst erzeugten Einzeldatenwert (D) verknüpft und den so erhaltenen Datenwert weitergibt, wodurch der von der letzten Dateneinheit (2-M, 3-M)weitergegebene Datenwert den abgeleiteten Datenwert darstellt,
**dadurch gekennzeichnet,**
**dass** jede Dateneinheit (2-i, 3-i) ihren Datenwert seriell in Form von aufeinanderfolgenden Abschnitten (rⱼ) empfängt, dass jede Dateneinheit (2-i, 3-i) einen empfangenen Abschnitt (rⱼ) mit dem entsprechenden Abschnitt (dⱼ) eines eigenen Einzeldatenwerts (D) verknüpft (S2-3, S2-9, S3-3), und dass sie das Ergebnis der Verknüpfung weitergibt (S2-4, S2-8, S2-13, S3-4), bevor sie einen weiteren empfangenen Abschnitt (rⱼ₊₁) des Datenwerts verknüpft (S2-2, S2-7, S2-12, S3-2).

2. Verfahren nach Anspruch 1
**dadurch gekennzeichnet,**
**dass** die Abschnitte (rⱼ, dⱼ) Bits sind.

3. Verfahren nach Anspruch 1 oder 2
**dadurch gekennzeichnet,**
**dass** die Verknüpfung (S2-3, S2-9, S3-3) der Abschnitte (rⱼ, dⱼ) unter Berücksichtigung des Ergebnisses der unmittelbar zuvor verknüpften Paars von Abschnitten erfolgt.

4. Verfahren nach einem der vorhergehenden Ansprüche,
**dadurch gekennzeichnet,**
**dass** der abgeleitete Datenwert (R) ein Minimum oder ein Maximum der Einzeldatenwerte (D) ist, und dass die Abschnitte (rⱼ) in der Reihenfolge abnehmender Signifikanz weitergegeben werden.

5. Verfahren nach Anspruch 1, 2 oder 3
**dadurch gekennzeichnet,**
**dass** der abgeleitete Datenwert (R) eine Summe oder eine Differenz der Einzeldatenwerte (D) ist, und dass die Abschnitte (rⱼ) in der Reihenfolge zunehmender Signifikanz weitergegeben werden.

6. Verfahren nach einem der vorhergehenden Ansprüche,
**dadurch gekennzeichnet,**
**dass** die Erfassung eines Einzeldatenwerts (D) ausgelöst wird durch Eingeben eines neutralen Datenwerts in die erste Dateneinheit (2-1, 3-1).

7. Verfahren nach einem der vorhergehenden Ansprüche,
**dadurch gekennzeichnet,**
**dass** ein Befehl zum Gewinnen eines Einzeldatenwerts allen Dateneinheiten (2-i, 3-i) gleichzeitig zugeleitet wird.

8. Verfahren nach einem der Ansprüche 1 bis 6,
**dadurch gekennzeichnet,**
**dass** ein Befehl zum Gewinnen eines Einzeldatenwerts sukzessive von einer Dateneinheit (2-i, 3-i) zur folgenden (2-(i+1)), 3-(i+1)) weiterübertragen wird.

9. Verfahren nach einem der vorhergehenden Ansprüche,
**dadurch gekennzeichnet,**
**dass** die Datenwerte Messgrößen, insbesondere Spannungen einer Reihenanordnung von elektrischen Energiequellen, insbesondere von Zellen eines Brennstoffzellenstapels sind.

10. Vorrichtung zum Erfassen eines abgeleiteten Datenwerts (R) aus einer Mehrzahl von Einzeldatenwerten (D), mit einer Mehrzahl von Dateneinheiten (2-i, 3-i) zum Erfassen der Einzeldatenwerte (D) , die über eine Datenleitung (4) zum Übertragen der Datenwerte (R) in Reihe verbunden sind, wobei jede Dateneinheit(2-i, 3-i), die einen Datenwert (R) über die Datenleitung empfängt, eingerichtet ist, diesen Datenwert (R) mit einem von ihr selbst erzeugten Einzeldatenwert (D) zu verknüpfen und den so erhaltenen Datenwert (R) auf der Datenleitung (4) weiterzugeben, wodurch der von der letzten Dateneinheit (2-M, 3-M) weitergegebene Datenwert den Wert der abgeleiteten Messgröße darstellt,
**dadurch gekennzeichnet,**
**dass** jede Dateneinheit (2-i, 3-i) ihren Datenwert (R) seriell in Form von aufeinanderfolgenden Abschnitten (rⱼ) weitergibt, und dass jede Dateneinheit(2-i, 3-i), die einen Abschnitt (rⱼ) eines Datenwerts (R) empfängt, eingerichtet ist, diesen mit dem entsprechenden Abschnitt (dⱼ) eines eigenen Einzeldatenwerts (D) zu verknüpfen und weiterzugeben, bevor sie einen weiteren Abschnitt (rᵢ₊₁) des Datenwerts (R) empfängt.

11. Vorrichtung nach Anspruch 10,
**dadurch gekennzeichnet,**
**dass** die ringförmige Datenleitung (4) über eine Steuereinheit (5) zum Auslösen einer Erfassung des abgeleiteten Datenwerts und Empfangen des erfassten Wertes verläuft.

12. Vorrichtung nach Anspruch 10 oder 11,
**dadurch gekennzeichnet,**
**dass** jede Dateneinheit (2-i, 3-i) ein Abtast-Halteglied aufweist.

13. Vorrichtung nach einem der Ansprüche 10 bis 12,
**dadurch gekennzeichnet,**
**dass** die Datenleitung (4) eine Mehrzahl von signaltechnisch getrennten Abschnitten umfasst, die sich jeweils von einem Sender einer ersten Dateneinheit (2-i, 3-i) zu einem Empfänger einer zweiten Dateneinheit (2-(i+1), 3-(i+1)) erstrecken.

14. Vorrichtung nach einem der Ansprüche 10 bis 13,
**dadurch gekennzeichnet,**
**dass** die Dateneinheiten durch eine Taktleitung (6) verbunden sind.

15. Vorrichtung nach Anspruch 14,
**dadurch gekennzeichnet,**
**dass** die Taktleitung (6) eine Mehrzahl von signaltechnisch getrennten Abschnitten umfasst, die sich jeweils von einem Sender einer ersten Dateneinheit (2-i, 3-i) zu einem Empfänger einer zweiten Dateneinheit (2-(i+1), 3-(i+1)) erstrecken, wobei der Sender jeder Dateneinheit das vom Empfänger der Dateneinheit empfangene Taktsignal mit einer vorgegebenen Verzögerung (t₂-t₀) weitergibt.

16. Vorrichtung nach einem der Ansprüche 10 bis 15, **dadurch gekennzeichnet, dass** jede Dateneinheit (2-i, 3-i) in wenigstens einem ASIC implementiert ist.

17. Verfahren zum Adressieren einer Dateneinheit aus einer Mehrzahl von Dateneinheiten, bei dem eine Reihenfolge der Dateneinheiten festgelegt wird, jede Dateneinheit, der eine Vorgänger-Dateneinheit zugeordnet ist, einen Adresswert von dieser Vorgänger-Dateneinheit empfängt (S5-2), den Adresswert mit einem für alle Dateneinheiten gleich vorgegebenen Wert vergleicht (S5-4), bei Übereinstimmung mit dem vorgegebenen Wert adressiert ist und wenigstens bei Nichtübereinstimmung den Adresswert durch eine vorgegebene Operation verändert (S5-6) und den so erhaltenen Adresswert weitergibt (S5-7).

18. Verfahren nach Anspruch 17, bei dem die vorgegebene Operation eine Inkrementierung oder eine Dekrementierung ist, bei dem jede Dateneinheit den Adresswert seriell in Form von aufeinanderfolgenden Abschnitten (aⱼ) zunehmender Signifikanz weitergibt (S5-7), und bei dem jede Dateneinheit, die einen Abschnitt eines Adresswerts empfängt, diesen je nachdem, ob zur Inkrementierung bzw. Dekrementierung nötig (S5-3), verändert (S5-6) oder nicht verändert, und ihn weitergibt (S5-7), bevor sie einen weiteren Abschnitt des Adresswerts empfängt.

19. Verfahren zum Erfassen eines einzelnen Datenwerts aus an einer Mehrzahl von Dateneinheiten erzeugten Einzeldatenwerten, bei dem eine der Dateneinheiten mit einem Verfahren nach Anspruch 17 oder 18 adressiert wird, die adressierte Dateneinheit einen Datenwert sendet und der Datenwert über eventuelle Nachfolger-Dateneinheiten der adressierten Dateneinheit weitergeleitet wird.

20. Vorrichtung, insbesondere nach einem der Ansprüche 10 bis 16, mit einer Mehrzahl von Dateneinheiten (2-i, 3-i) zum Erfassen von Einzeldatenwerten (D), die über eine Adressleitung in Reihe verbunden sind, wobei jede Dateneinheit eingerichtet ist, einen über die Adressleitung empfangenen Adresswertwert (aⱼ) mit einem für alle Dateneinheiten gleich vorgegebenen Wert zu vergleichen, bei Übereinstimmung einen Datenwert (D) auf eine Datenleitung (4) auszugeben und wenigstens bei Nichtübereinstimmung den Adresswert durch eine vorgegebene Operation zu verändern und den so erhaltenen Adresswert an eine in der Reihe nachfolgende Dateneinheit (2-(i+1), 3-(i+1)) weiterzugeben.
